Europäisches Patentamt

European Patent Office

Office européen des brevets

(11) Publication number: **0 504 425 A1**

## EUROPEAN PATENT APPLICATION
### published in accordance with Art. 158(3) EPC

(21) Application number: **91917336.9**

(22) Date of filing: **04.10.91**

(86) International application number:
**PCT/JP91/01346**

(87) International publication number:
**WO 92/06500 (16.04.92 92/09)**

(51) Int. Cl.⁵: **H01L 27/115**

(30) Priority: **05.10.90 JP 267602/90**

(43) Date of publication of application:
**23.09.92 Bulletin 92/39**

(84) Designated Contracting States:
**DE FR GB IT NL**

(71) Applicant: **SEIKO EPSON CORPORATION**
**4-1, Nishishinjuku 2-chome**
**Shinjuku-ku Tokyo 163(JP)**

(72) Inventor: **TAKENAKA, Kazuhiro**
**3-5 Owa 3-chome, Suwa-shi**
**Nagano-ken, 392(JP)**

(74) Representative: **Ouinterno, Giuseppe et al**
**c/o Jacobacci-Casetta & Perani S.p.A. Via Alfieri, 17**
**I-10121 Torino(IT)**

(54) **SEMICONDUCTOR DEVICE.**

(57) In the structure of a memory in which capacitors using ferroelectric substances (109) are integrated on a semiconductor substrate, particularly in the structure of certain one of unit cells forming the memory, an electrode (110) of the ferroelectric capacitor and the source diffusion layer constituting a MOS transistor are connected by a wiring electrode (107). The drain diffusion layer constituting the MOS transistor is connected with a first wiring electrode (114) containing, e.g. Al as its main component. The other electrode (113) of the capacitor is used as a second wiring electrode, leaving as it is. A third wiring electrode (108) containing, e.g. Al as its main component is disposed in parallel with the second wiring electrode, and is connected with the first wiring electrode directly or via the second wiring electrode. Thereby, the memory is suited to larger scale integration, and able to operate at a high speed.

Fig. 1

## FIELD OF THE INVENTION

The present invention relates to a structure of a memory using a ferroelectric material, particularly to a non-volatile memory capable of electric re-writing.

## BACKGROUND OF THE INVENTION

As a conventional semiconductor non-volatile memory, MIS transistors are usually used, which make use of a phenomenon that the surface potential of a silicon substrate can be modified through the injection of charge from the silicon substrate into an insulating gate trap or a floating gate, and are practically used as an EPROM (ultra-violet ray erasing type non-volatile memory) and an EEPROM (electrically rewritable non-volatile memory).

These non-volatile memories, however, have disadvantages that an information re-writing voltage is usually as high as about 20 V and that the re-writing time is extremely long (for instance, several tens of msec. in the case of the EEPROM). In addition, the number of times of re-writing of the information is very small, typically about $10^5$ times, thus posing problems in case of repeated use.

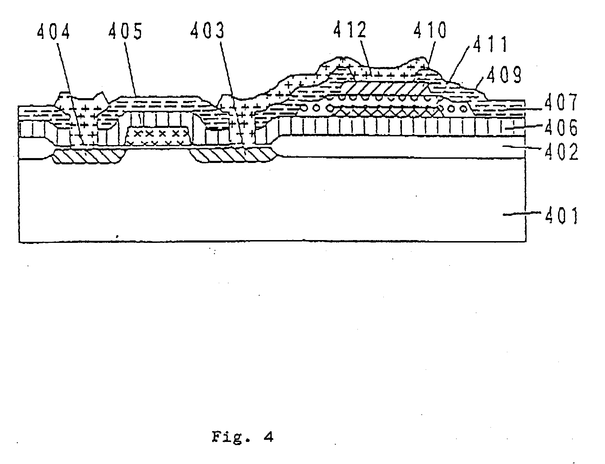

With a non-volatile memory using a ferroelectric material capable of electrically inverting polarization, the writing-in and reading-out times are substantially the same in principle, and also the polarization is maintained even if the power source is disconnected. Thus, the memory is possibly an ideal non-volatile memory. As such a non-volatile memory using a ferroelectric material, there has been proposed a structure, in which a ferroelectric capacitor is integrated on a silicon substrate as shown in United States Patent No. 4,149,302, and a non-volatile memory, which has a ferroelectric film provided on a gate portion of a MIS transistor as shown in United States Patent No. 3,832,700. Further, recently a non-volatile memory having a laminate structure of a MOS semiconductor device as shown in Fig. 4 has been reported in the IEDM, '87 pp, 850-851. In Fig. 4, 401 designates a P-type Si substrate, 402 a LOCOS oxide film for isolation, 403 an N-type diffusion layer constituting a source, 404 an N-type diffusion layer constituting a drain, 405 a gate electrode, and 406 an interlayer insulation film. Designated at 409 is a ferroelectric film, which constitutes a capacitor together with electrodes 410 and 411 having the ferroelectric film therebetween. 407 illustrates a second insulation film and 412 designates Al constituting a lead electrode.

Now, in the ferroelectric memory of this kind of structure, the lower electrode 411 is formed for instance of Pt and the like in order to improve the crystallization of the ferroelectric film, and is often used as it is as a wiring electrode too, but the specific resistance of Pt is higher than Al etc. by more than about one digit. Thus when using Pt as the wiring electrode, the wiring resistance increases thereby causing delay in an input clock signal, which results in not attaining high speed operation. Then, the present invention seeks to solve this problem, and its object is to provide a ferroelectric memory which is capable of high speed operation without causing a delay of a clock signal.

## DISCLOSURE OF THE INVENTION

The present invention is to provide a memory structure in which a capacitor using ferroelectric substance is integrated on a semiconductor device substrate, and more particularly to a structure of a unit cell forming a memory. The structure is characterized in that one of electrodes of the ferroelectric capacitor is connected to a source diffusion layer constituting a MOS transistor, that a drain diffusion layer constituting the MOS transistor is connected to the first wiring electrode of main ingredient of Al, for instance, that the other electrode of the capacitor is used as the second wiring electrode as it is, and that the third wiring electrode of the main ingredient of Al, for instance, is arranged parallel to the second wiring electrode and is connected to the first wiring electrode directly or through the second wiring electrode.

## BRIEF DESCRIPTION OF THE DRAWINGS

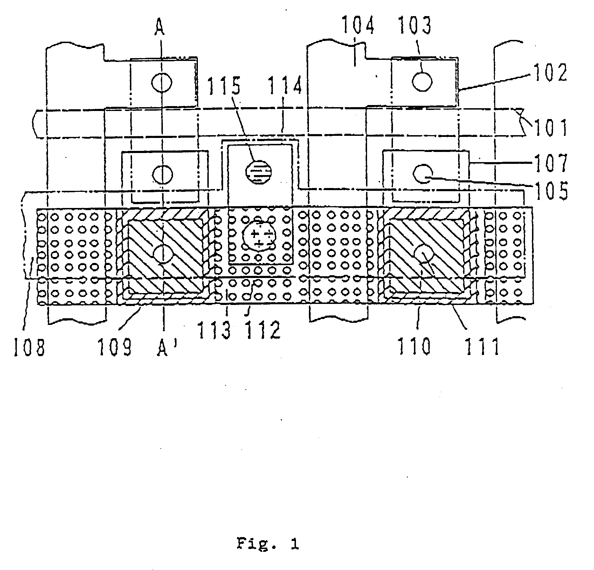

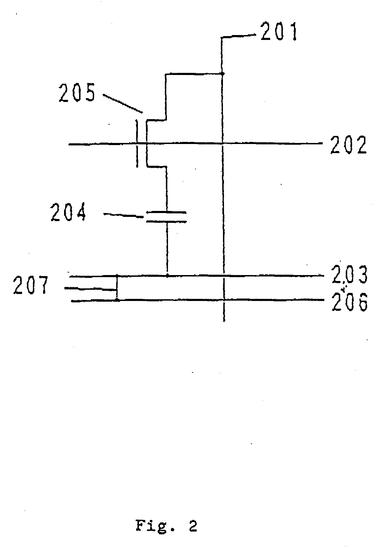

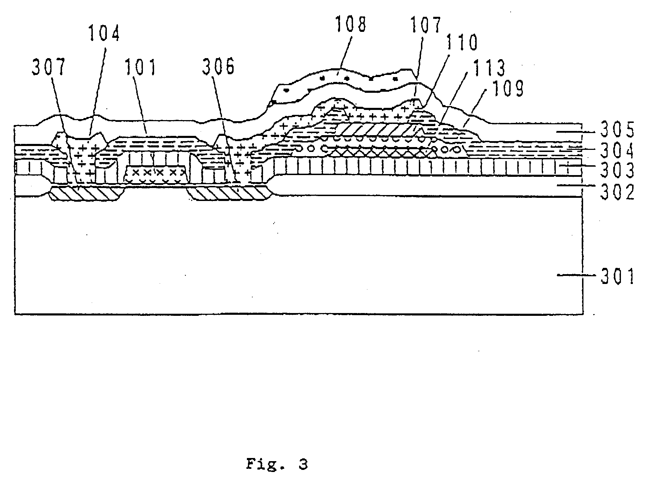

Fig. 1 is a plane view showing an embodiment of the present invention, Fig. 2 is a circuit diagram, and Fig. 3 is a sectional figure. Fig. 4 is a sectional view showing a conventional semiconductor memory.

Fig. 1 is a main plane view showing one embodiment of a semiconductor device of the present invention, Fig. 2 is a circuit diagram showing a unit-cell of the memory. And Fig. 3 is a sectional view of A-A' of Fig. 1, showing one embodiment of the present invention.

The present invention will be described in detail with reference to Figs. 1, 2 and 3. A reference numeral 101 designates a gate electrode formed of poly-Si etc. and constituting a word line at the same time. A reference numeral 102 shows a MOS transistor region, and a drain diffusion layer is connected to a bit line formed of a wiring electrode 104 through a contact hole 103. A reference numeral 110 illustrates an upper or outer electrode of a ferroelectric capacitor. The upper electrode is connected to a wiring electrode 107 through a contact hole 111, and is connected further to a source diffusion layer of a MOS transistor through a contact hole 105. A reference numeral 109 shows a ferroelectric substance (it is also formed under the upper electrode 110) and 113 a lower electrode. The lower or inner electrode 113 constitutes by itself a wiring electrode of each memory cell.

A reference numeral 108 designates the second wiring electrode provided, based upon the gist of the present invention, in parallel with the lower electrode 113. A reference numeral 112 shows a contact hole through which the lower electrode 113 and the first wiring electrode 114 are connected to each other, and further through a contact hole 115 to the second wiring electrode 108. It is needless to say that the wording "parallel" here does not mean geometrical correlation.

Now, Fig. 2 shows a circuit diagram of the unit memory cell shown in Fig. 1. A reference numeral 201 shows a bit line (104 in Fig. 1) and 205 a MOS transistor for selecting a ferroelectric capacitor 204. A reference numeral 202 designates a word line (101 in Fig. 1) and 203 a wiring formed of the lower electrode of the ferroelectric capacitor (113 in Fig. 1). A reference numeral 206 designates the second wiring electrode based upon the gist of the present invention (113 in Fig. 1) the electrode being connected to the wiring 203 through 207.

Next, the operation of the present invention will be described. A metal having a high melting point such as Pt is often used to form the lower electrode 113 in view of the crystallization of the ferroelectric film. These high melting point metals have the higher resistivity by about one digit as compared with Al etc. Also, the film thickness should be kept thin (about 1000 Å) to lessen the level difference of a step. As a result of this, the wiring resistance of the wiring 203 becomes very high. When the wiring resistance of the wiring 203 becomes high, the time constant T of a clock signal supplied to the ferroelectric capacitor 204 becomes very large according to the equation

$$T = CR,$$

while C shows a capacitance of the ferroelectric capacitor, 209 and R the wiring resistance, as the result of which the high speed operation will not be expected. According to the present invention, the second wiring electrode 108 is formed, for example, of Al and is connected to the lower electrode 113, so that the wiring resistance R of 203 and 206 becomes very small and high speed operation is made possible. As to the connection of 207 with 203 and 206, it can be properly set, for example, at every 256 bits, depending on the resistance value of 203 or 206.

In the structure shown in Fig. 1, the connection between the lower electrode 113 and the second wiring electrode 108 is conducted through the first wiring electrode 114, but this connection may also accomplished directly, that is, without using the first wiring electrode.

Now, a structure of the present invention will be described with reference to the sectional view of Fig. 3. Here, for the sake of brevity, the description concerns an example, in which an N-channel transistor is used. However, the description is also applicable to a P-channel transistor. A reference numeral 301 designates a P-type S-i substrate, which may, for exampel, be a wafer with a resistivity of 20 Ohm•cm. A reference numeral 302 designates a $SiO_2$ film for isolation, which is formed to a thickness of 6000 Å by using the conventional LOCOS method. A reference numeral 101 shows, for example, poly-Si intended to form a gate electrode, which is grown by a vapor phase growing method up to a thickness of 5000 Å. At the same time, the layer 101 becomes a word line. A reference numeral 303 illustrates an interlayer insulation film for separating the gate electrode from a ferroelectric film, the interlayer insulation film being formed, for example, of $SiO_2$ with a thickness of 4000 Å. A reference numeral 113 shows a lower electrode of the ferroelectric capacitor, which is formed, for example, of Pt with a thickness of 3000 Å. A reference numeral 109 shows the ferroelectric film, which is formed, for example, of PZT with a thickness of 6000 Å by the sputtering method. A reference numeral 110 shows an upper electrode, which is formed, for example, of Pt with a thickness of 2000 Å by the sputtering method. A reference numeral 306 designates an N-type diffusion layer intended to form a source of a MOS transistor and is formed by, for example, 5E15 cm-2 ion implantation of phosphorous. The source diffusion layer is connected to the upper electrode of the ferroelectric capacitor by, for example, Al of the first wiring layer 107. A reference numeral 307 designates an N-type diffusion layer intended to form a drain of the MOS transistor, and acts as a bit line through the first wiring electrode 104 of Al. A reference numeral 304 shows an interlayer insulation film for separating the ferroelectric capacitor from the first wiring electrode of Al, and the interlayer insulation film is formed, for example, of $SiO_2$ grown to a thickness of 5000 Å. A reference numeral 108 designates the third wiring electrode provided based upon the gist of the present invention, and is formed, for example, of Al of 1 $\mu$m thickness by using the sputtering method. The structure of the present invention is thus obtained.

APPLICABILITY IN THE INDUSTRY

As described above, according to the present invention, in a structure of a unit cell of a memory using a ferroelectric substance, one of electrodes of the ferroelectric capacitor is connected to a source diffusion layer constituting a MOS transistor, that a drain diffusion layer constituting the MOS transistor is connected to the first wiring electrode of a main ingredient of Al, for instance, that the other electrode of the capacitor is used as the second wiring electrode as it is, and that the third wiring electrode of the main ingredient of Al, for instance, is arranged parallel to the second wiring electrode and is connected to the first wiring electrode directly or through the second wiring electrode. Therefore, effects are obtained such that the structure is suitable for integration and that high speed operation is made possible due to the decrease of the wiring resistance.

**Claims**

1. A semiconductor device in which at least one capacitor having a ferroelectric substance and a MOS transistor are integrated on one and the same semiconductor substrate, which is characterized in that

   one of electrodes of the capacitor is connected to the first high density diffusion layer constituting the MOS transistor, that the second high density diffusion layer constituting the MOS transistor is connected to the first wiring electrode

   that the other electrode of the capacitor serves as the second wiring electrode,

   and that the third wiring electrode is arranged in parallel with the second wiring electrode and is connected to the second wiring electrode through the first wiring electrode.

2. A semiconductor device in which at least one capacitor having a ferroelectric substance and a MOS transistor are integrated on one and the same semiconductor substrate, which is characterized in that

   one of electrodes of the capacitor is connected to the first high density diffusion layer constituting the MOS transistor, that the second high density diffusion layer constituting the MOS transistor is connected to the first wiring electrode

   that the other electrode of the capacitor serves as the second wiring electrode,

   and that the third wiring electrode is arranged in parallel with the second wiring electrode and is connected directly to the second wiring electrode.

Fig. 1

Fig. 2

Fig. 3

Fig. 4

# INTERNATIONAL SEARCH REPORT

International Application No  PCT/JP91/01346

| I. CLASSIFICATION OF SUBJECT MATTER (if several classification symbols apply, indicate all) 6 |
|---|

According to International Patent Classification (IPC) or to both National Classification and IPC

Int. Cl$^5$  H01L27/115

| II. FIELDS SEARCHED |
|---|

Minimum Documentation Searched 7

| Classification System | Classification Symbols |
|---|---|
| IPC | H01L27/115, 29/792, 27/108 |

Documentation Searched other than Minimum Documentation
to the Extent that such Documents are Included in the Fields Searched 8

Jitsuyo Shinan Koho              1964 - 1990
Kokai Jitsuyo Shinan Koho        1973 - 1990

| III. DOCUMENTS CONSIDERED TO BE RELEVANT 9 | | |
|---|---|---|
| Category * | Citation of Document, 11 with indication, where appropriate, of the relevant passages 12 | Relevant to Claim No. 13 |
| Y | JP, A, 2-208978 (Seiko Epson Corp.), August 20, 1990 (20. 08. 90), Lines 1 to 12, upper right column, page 2 | 1, 2 |
| Y | JP, A, 60-211871 (NEC Corp.), October 24, 1985 (24. 10. 85), Line 11, upper right column to line 13, lower right column, page 4 & US, A, 4771322 & EP, A2, 157428 | 1, 2 |
| A | JP, A, 2-36563 (Hitachi, Ltd.), February 6, 1990 (06. 02. 90) | 1, 2 |

* Special categories of cited documents: 10

"A"  document defining the general state of the art which is not considered to be of particular relevance

"E"  earlier document but published on or after the international filing date

"L"  document which may throw doubts on priority claim(s) or which is cited to establish the publication date of another citation or other special reason (as specified)

"O"  document referring to an oral disclosure, use, exhibition or other means

"P"  document published prior to the international filing date but later than the priority date claimed

"T"  later document published after the international filing date or priority date and not in conflict with the application but cited to understand the principle or theory underlying the invention

"X"  document of particular relevance; the claimed invention cannot be considered novel or cannot be considered to involve an inventive step

"Y"  document of particular relevance; the claimed invention cannot be considered to involve an inventive step when the document is combined with one or more other such documents, such combination being obvious to a person skilled in the art

"&"  document member of the same patent family

| IV. CERTIFICATION | |
|---|---|
| Date of the Actual Completion of the International Search | Date of Mailing of this International Search Report |
| December 27, 1991 (27. 12. 91) | January 21, 1992 (21. 01. 92) |
| International Searching Authority | Signature of Authorized Officer |
| Japanese Patent Office | |